# EUROPÄISCHE PATENTSCHRIFT

(11) **EP 0 995 235 B1**
(45) Veröffentlichungstag und Bekanntmachung des Hinweises auf die Patenterteilung: **03.04.2002**
(21) Anmeldenummer: 98936426.0
(22) Anmeldetag: 16.07.1998
(51) Int. Cl.: H01R 4/02, H01R 12/04

(54) **KONTAKT FÜR KLEINSTE BONDKONTAKTE SOWIE VERFAHREN ZUR HERSTELLUNG EINES KONTAKTES**
CONTACT FOR VERY SMALL LIAISON CONTACTS AND METHOD FOR PRODUCING A CONTACT
CONTACT POUR DE MINUSCULES CONTACTS DE LIAISON ET PROCEDE DE PRODUCTION D'UN CONTACT

(30) Priorität: 16.07.1997 DE 19730388
(43) Veröffentlichungstag der Anmeldung: 26.04.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: BEUTEL, Hansjörg, D-66440 Blieskastel (DE)
(74) Vertreter: Münich, Wilhelm, Dr.
(86) Internationale Anmeldenummer: EP9804412
(87) Internationale Veröffentlichungsnummer: WO9904453

(56) Entgegenhaltungen:
- EP-A2- 0 814 539
- DE-A1- 4 132 995
- DE-B1- 2 945 670
- SE-B- 459 832
- Patent Abstracts of Japan, Band 13, Nr 176(E-749); & JP,A,016385 (CANON INC), 1989-01-10

## Beschreibung

### Technisches Gebiet

Die Erfindung bezieht sich auf einen Kontakt, der ein erstes Teil, wie ein Substrat mit einem zweiten Teil mittels einer Bondverbindung mechanisch und/oder elektrisch verbindet, gemäß dem Oberbegriff des Anspruchs 1 sowie auf ein Verfahren zur Herstellung eines derartigen Kontakts und die Verwendung eines entsprechenden Kontakts bzw. Verfahrens.

Derartige Kontakte werden in zahlreichen Anwendungen eingesetzt; eine bevorzugte Anwendung derartiger Kontakte ist die Herstellung miniaturisierter Verbindungen, die auf kleinstem Raum angeordnet sind. Die miniaturisierten Kontakte werden beispielsweise in der Mikroelektronik, der Neuroprothetik oder der Implantatmedizin eingesetzt.

Beispielsweise in der Mikroelektronik ist es regelmäßig erforderlich, verschiedene elektronische Bauteile wie integrierte Schaltkreise, Leiterplatten, Substrate, Hybride oder dergleichen miteinander zu verbinden. Die Herstellung solcher mechanischer, elektrisch leitender Verbindungen erfolgt üblicherweise mit einem Verfahren, das allgemein als "Bonden" bezeichnet wird.

Zur Herstellung dieser Verbindungen werden häufig flächige, dünne Bondstrukturen eingesetzt, wie etwa flexible, dünne und schmale Leiterbahnen, die mit den genannten, als Substrat dienenden Bauteilen mechanisch und damit auch elektrisch verbunden werden müssen. Als Substrat für das Anbringen solcher flexibler Strukturen können ungehäuste monolithisch integrierte Schaltkreise, aber auch beliebige andere bondbare Materialoberflächen eingesetzt werden.

In der Neuroprothetik werden dünne, flexible und mit dem Körper zu verbindende Leiterbahnstrukuren eingesetzt, um Nerven zu stimulieren oder Nervensignale abzuleiten. Dabei sind ebenso wie in der Implantatmedizin entsprechende Anforderungen an die Körperverträglichkeit der zum Bonden verwendeten Materialien zu stellen.

Weitere Anwendungsgebiete ergeben sich überall dort, wo insbesondere flexible Bondstrukturen eingesetzt werden können, etwa in der Uhrenindustrie oder in der Unterhaltungselektronik etc.

Die zunehmende Miniaturisierung bringt es mit sich, daß die Abstände zwischen den einzelnen Leiterbahnen und damit auch zwischen ihren Kontaktierflächen, d.h. den Einzelkontakten immer weiter verkleinert werden; so liegen typische Abstände zwischen den Bondkontakten benachbarter Leiterbahnen, die sog. Pitchabstände, derzeit bei 100 µm und darunter.

### Stand der Technik

Zur Herstellung sog. Bondkontakte sind zahlreiche Verfahren bekannt:

Bei dem sog. Drahtbondverfahren wird die Verbindung zwischen zwei Bauelementen durch einen flexiblen Bonddraht hergestellt, der mit Hilfe eines Drahtbondgerätes nacheinander an beiden Bauelementen (oder an einem Bauelement und einem Verdrahtungsträger oder dergleichen) befestigt wird. Die Befestigung jedes einzelnen Kontaktes erfolgt dadurch, daß der Bonddraht auf eine Kontaktierfläche des jeweiligen Bauelements gepreßt und dort mit Hilfe von Ultraschall, Thermokompression oder einer anderen Schweißverbindungstechnik verlötet wird.

Hinsichtlich der Zuführung des Bonddrahtes zur Lötstelle und der Form seines zu verlötenden Bereichs sind insbesondere zwei Methoden gebräuchlich, das Kugelbond- und das Keilbond-Verfahren:

Beim Kugelbonden wird der Bonddraht der zu bondierenden Oberfläche mit Hilfe einer Bondkapillare unter einem rechten Winkel zugeführt; das aus einer der Bauelementoberfläche zugewandten trichterförmigen Aufweitung der Bonddrahtfassung herausragende Bonddrahtende wird zu einer Kugel angeschmolzen. Dieses Kugelanschmelzen geschieht in der Regel mit Hilfe einer Wasserstoff-Mikroflamme oder durch eine elektrische Funkenentladung. Die so erzeugte Bondkugel wird dann auf den zu bondierenden Untergrund gebracht dort in der oben beschriebenen Weise verlötet.

Das Keilbonden unterscheidet sich demgegenüber durch die Zuführung des Bonddrahtes unter einem Winkel von typischerweise 30° - 60° zur Kontaktfläche. Das freie Bonddrahtende wird nicht zu einer Kugel geformt, sondern unter eine zur Kontaktfläche des Untergrunds in etwa parallele Fußfläche auf der Unterseite der Bondkapillare gebracht, die das Bonddrahtende auf den Untergrund preßt. Auf diese Weise gelangt das Drahtstückende als "Keil" auf den Untergrund. Die Verlötung erfolgt wiederum mit Hilfe der oben beschriebenen Schweißverbindungstechniken.

Da mit Hilfe des Bonddrahtes zwei Kontaktstellen miteinander verbunden werden, bezeichnet man das Drahtbondverfahren je nach Art der Anbringung des ersten Kontaktes als Kugel-Keil-Bonden (ball-wedge-bonding) oder Keil-Keil-Bonden (wedge-wedge-bonding). Der zweite Kontakt wird jeweils dadurch hergestellt, daß ein entsprechend weiter gelegenes Teilstück des an einem Ende bereits befestigten Bonddrahtes nach dem Keilbondverfahren an dem zweiten Bauelement befestigt und der Bonddraht dahinter abgetrennt wird.

Neben dem Drahtbonden, bei dem Drähte als Zwischenleiter benötigt werden, sind auch Verfahren zu Herstellung direkter Kontakte zwischen den Bondstrukturen bekannt, beispielsweise die sog. beam-lead-Technik, bei der flexible bändchenförmige Bondstrukturen (beam leads), die über den Rand des jeweiligen Bauelements herausragen, an denen eines anderen Bauelements befestigt werden.

Jedoch bedingt diese Technik - wie auch das Drahtbondverfahren - einen hohen Materialaufwand für das Bondmaterial und hat bei der Verwendung etwa von Gold entsprechende Produktionskosten zur Folge.

Andere Verfahren, bei denen die Bondkontakte schon während der Fertigung der Bauelemente selbst als deren Bestandteil entstehen, kommen im allgemeinen zwar mit geringeren Mengen aus; so werden beispielsweise bei der flip-chip-Technik auf mindestens einem der Bauelemente starre Bondhügel modelliert, die bei face-down-Montage des anderen Bauelements den Kontakt herstellen. Diese Technik ist gegenüber dem Drahtbonden jedoch aufgrund der Vielzahl erforderlicher Prozeßschritte und Prozeßmedien sowie aufgrund der verfahrensbedingten Untergrenze des Pitchabstands von etwa 200 µm nachteilig.

Zudem sind die verwendeten Materialien, wie SnPb oder Cu nur bedingt CMOS-kompatibel und eignen sich wegen ihrer Giftigkeit nicht für den Einsatz in der Neuroprothetik. Ferner die flip-chip-Technik wie auch jedes andere Simultanbondverfahren mit großen Eingriffen in die Herstellung der Bauelemente - Lithographie, Beschichtungsprozesse, Justiervorgänge etc. - selbst verbunden und daher kein Ersatz für serielle Techniken wie dem Drahtbonden.

Die vorstehenden Darlegungen zeigen, daß die gängigen Verfahren zur Herstellung von Bondkontakten dann, wenn kleinste Bondkontakte erzeugt werden sollen, mit hohen Kosten verbunden sind, die durch den Materialaufwand und/oder durch ihre aufwendige Handhabung bzw. Vorgehensweise entstehen. Darüber hinaus weisen die bekannten Verfahren auch in Bezug auf die erzielbaren minimalen Pitchabstände Begrenzungen auf.

### Darstellung der Erfindung

Es ist Aufgabe der Erfindung, einen Kontakt, der ein erstes Teil, d.h. einen festen Untergrund, wie ein Substrat, mit einem zweiten Teil, wie einem zweiten Substrat d.h. einer flächigen, dünnen Leiterbahn, (i.f. als Bondstruktur bezeichnet) mittels einer Bondverbindung mechanisch und elektrisch verbindet, derart weiterzubilden, daß die beiden Teile bei einem Pitchabstand bis hinunter zu 50 µm mechanisch und elektrisch auf möglichst einfache, zeit- und kostensparende Weise verbunden werden können.

Eine erfindungsgemäße Lösung dieser Aufgabe ist für einen Kontakt im Anspruch 1 und für das Herstellungsverfahren im Anspruch 6 angegeben. Verwendungen sind Gegenstand der Ansprüche 10 folgende. Weiterbildungen der Erfindung sind Gegenstand der abhängigen Ansprüche.

Die erfindungsgemäß gestellte Aufgabe wird für einen Kontakt dadurch gelöst, daß die Bondstruktur ein Loch aufweist, daß die Bondverbindung im wesentlichen ein Bondelement ist, das sich vom Untergrund durch das Loch in der Bondstruktur hindurch bis zu einem oberhalb der Bondstruktur gelegenen Bereich erstreckt, und daß sich das Bondelement in dem oberhalb der Bondstruktur gelegenen Bereich seitlich zumindest teilweise über das Loch in der Bondstruktur hinaus erstreckt und dadurch die Berührung des Untergrunds mit der Unterseite der Bondstruktur sichert.

Für das Herstellungsverfahren wird die Aufgabe dadurch gelöst, daß der Bondkopf durch ein Loch in der Bondstruktur hindurch größtenteils direkt auf den Untergrund gebondet wird, und die Bondstruktur dabei von dem Bondkopf gegen den Untergrund gepreßt wird.

Das zweite Teil ist angesichts der typischen Breite von Leiterbahnen von 100 µm und weniger und der ebenfalls sehr geringen Dicke in aller Regel eine flächige, dünne und flexible Bondstruktur und weist ebenso wie das erste Teil, das insbesondere ein fester Untergrund sein kann, eine zur Bondierung geeignete Kontaktierfläche auf. Das Loch in der flexiblen Leiterbahn (zumeist im Zentrum der Kontaktierfläche) ermöglicht die gleichzeitige Kontaktierung von Leiterbahn und Untergrund auf engstem Raum und in einem Arbeitsschritt. Dementsprechend gering ist der für die Bondierung nötige Materialverbrauch und Arbeits- und Zeitaufwand.

Als Ausrüstung zur Durchführung des erfindungsgemäßen Verfahrens ist ein Ultraschall-Schweißgerät ausreichend.

Dadurch wird die kostensparende Verarbeitung insbesondere auch kleiner Stückzahlen möglich. Ein weiterer Vorteil des erfindungsgemäßen Verfahrens liegt darin, daß mit diesem Verfahren bereits die handelsüblichen IC's mit ihren Standard-Aluminium-Kontakten gebondet werden können.

Der mechanische Kontakt entsteht durch das Bondelement, das während des erfindungsgemäßen Verfahrens durch Verformung des Bondkopfes entsteht. Dieser Bondkopf (in Form einer Bondkugel oder eines Bondkeils) ist größer als das Loch in der Bondstruktur. Er wird daher nicht nur selbst durch das Loch auf die Kontaktierfläche des Untergrunds gepreßt, sondern preßt außerhalb des Lochs auch die Bondstruktur gegen den Untergrund. Dadurch erhält das Bondelement beim Verformen einen im einfachsten Fall pilzförmigen Querschnitt, wobei der dem Pilzkopf entsprechende Bereich oberhalb der Bondstrukturoberfläche einen dauerhaften mechanischen Kontakt von Bondstruktur und Untergrund gewährleistet.

Eine erste erfindungsgemäße Ausführungsform sieht vor, daß die Bondstruktur auf ihrer Oberseite in der Nähe des Lochs leitend ist, so daß sie durch das Bondelement mit dem Untergrund auch elektrisch verbunden ist.

Gemäß einer zweiten erfindungsgemäßen Ausführungsform ist die Bondstruktur auf ihrer Unterseite in der Nähe des Lochs leitend, berührt dort den Untergrund und ist mit ihm durch diesen direkten Kontakt elektrisch verbunden. Das Bondelement stellt hier durch seinen oberhalb der Bondstruktur gelegenen Bereich die mechanische Verbindung von Leiterbahn und Untergrund und damit indirekt auch die elektrische Verbindung sicher.

Da das Bondmaterial bei dem erfindungsgemäßen Verfahren lediglich gepreßt bzw. verformt wird, kann im Prinzip jedes bondfähige Material verwendet werden,

Gemäß einer weiteren Ausführungsform wird als Bondmaterial Gold verwendet, das aufgrund seiner hohen chemischen Beständigkeit gerade für medizinsche Anwendungen verwendet wird.

Eine vorteilhafte Ausführungsform der Erfindung sieht vor, daß die Bondstruktur mit Hilfe des Lochs parallel zur Oberfläche des Untergrunds justiert wird. Da der Untergrund bzw. seine Kontaktierfläche durch das Loch in der (transparenten oder auch undurchsichtigen) Leiterbahn hindurch sichtbar ist, wird so die vor der Kontaktierung zunächst erforderliche Justierung der Leiterbahn erleichtert.

Eine weitere Ausführungsform sieht vor, daß der Bondkopf in an sich bekannter Weise durch Anschmelzen eines Bonddrahtes als Bondkugel geformt wird. So ist es auf einfache Weise möglich, den Durchmesser des Bondkopfes über den Durchmesser des Lochs hinaus zu vergrößern, so daß die Bondstruktur in der Umgebung des Lochs durch die Bondkugel bedeckt wird.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird. Es zeigen:
- Fig. 1: ein erstes Ausführungsbeispiel, und
- Fig. 2: ein ein zweites Ausführungsbeispiel des erfindungsgemäßen Verfahrens.

### Darstellung von Ausführungsbeispielen

Bei beiden Ausführungsbeispielen soll eine flexible Leiterbahn (1), die insbesondere einen geringen Abstand der Einzelkontakte aufweisen kann, mit einem Substrat (4) oder einem sonstigen festen Untergrund verbunden werden. Hierzu weist die Leiterbahn (1) an den Kontaktstellen Löcher (2) auf.

Bei beiden Ausführungsbeispielen ist das Substrat (4) in der Umgebung der Löcher (2) auf der Oberseite mit Kontaktierflächen (5) für die Bondierung versehen. Zusätzlich oder alternativ kann die Leiterbahn an ihrer Oberseite und/oder Unterseite komplementäre Kontaktierflächen (3) aufweisen.

Die flexible Leiterbahn (1) wird relativ zum Substrat bzw. Untergrund (4) so justiert, daß sich die jeweiligen Kontaktierflächen (3) und (5) in etwa deckungsgleich übereinander befinden. Durch das Loch (2) in der Leiterbahn (1) erfolgt die Bondierung.

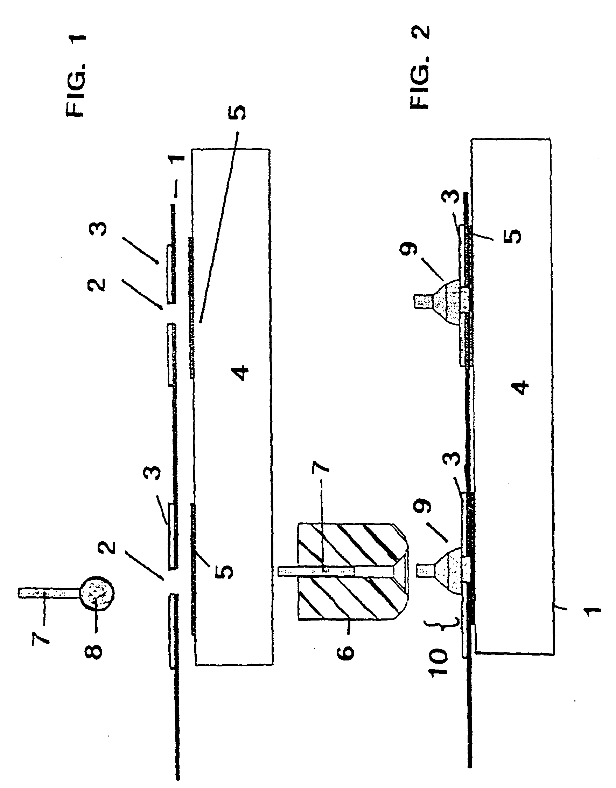

Bei dem in Fig. 1 dargestellten ersten Ausführungsbeispiel wird mit Hilfe von Kugelanschmelzen an einen Bonddraht (7) eine Kugel (8) angeschmolzen.

Bei dem in Fig. 2 dargestellten Ausführungsbeispiel wird mit Hilfe eines Drahtbondverfahrens durch eine Bondkapillare (6) ein Bonddraht (7) bereitgestellt.

Die Bondkapillare (6) ist in Zuführrichtung, d. h. auf der der Leiterbahn zugewandten Seite, trichterförmig aufgeweitet. An dem aus ihr herausragende Ende des Bonddrahtes (7) wird - ebenfalls durch Kugelanschmelzen - ein Bondkopf (8) hergestellt. Dieser wird in eine Position oberhalb eines Lochs in der Leiterbahn gebracht und auf die Leiterbahn bzw. den Untergrund gepreßt. Dabei wird der Bondkopf während des Pressens zu einem Bondelement (9) verformt, wobei durch Schweißen unter Ultraschalleinwirkung die feste Verbindung des Bondelements mit der Leiterbahn und dem Untergrund entsteht.

Die Form des Bondelements in dem oberhalb der Leiterbahn gelegenen Bereich (10) wird durch die trichterförmige Aufweitung der Bondkapillare geprägt und ist so gestaltet, daß sie die Kontaktierfläche der Leiterbahn in der Nähe des Lochs zumindest teilweise bedeckt. Wenn die Bondkapillare von der gerade gefertigten Bondverbindung entfernt wird, reißt der Bonddraht kurz oberhalb der Bondverbindung ab und kann für die nächste Kontaktierung wieder nachgeführt werden.

Alternativ kann der Bondkopf durch Umformen eines Aluminiumdrahtes gebildet werden.

## Patentansprüche

1. Kontakt für kleinste Bondkontakte, der ein erstes, von einem festen Untergrund (4) gebildetes Teil mit einem zweiten, von einer flächigen, dünnen Leiterbahn, (Bondstruktur (1) gebildeten Teil mittels einer Bondverbindung mechanisch und elektrisch mit einem möglichen Pitchabstands zwischen benachbarter Leiterbahnen weniger als 100 µm verbindet,
**dadurch gekennzeichnet, daß** das zweite Teil ein Loch (2) aufweist, daß die Bondverbindung im wesentlichen ein Bondelement oder Bondkopf (9) ist, das sich vom Untergrund durch das Loch in der Leiterbahn hindurch bis zu einem oberhalb der Leiterbahn gelegenen Bereich (5) erstreckt, und daß sich das Bondelement in dem oberhalb der Leiterbahn gelegenen Bereich seitlich zumindest teilweise über das Loch in der Leiterbahn hinaus erstreckt und dadurch die Berührung des ersten Teils mit der Unterseite der Leiterbahn sichert.

2. Kontakt nach Anspruch 1,
**dadurch gekennzeichnet, daß** zur elektrischen Verbindung das zweite Teil auf ihrer Oberseite in der Nähe des Lochs leitend ist, und durch das Bondelement mit dem ersten Teil elektrisch verbunden ist.

3. Kontakt nach Anspruch 1,
**dadurch gekennzeichnet, daß** das zweite Teil auf ihrer Unterseite in der Nähe des Lochs leitend ist, dort das erste Teil berührt und im wesentlichen dadurch mit dem ersten Teil elektrisch verbunden ist.

4. Kontakt nach einem der Ansprüche 1 bis 3,
**dadurch gekennzeichnet, daß** mehrere Einzelkontakte vorgesehen sind, deren Abstand (Pitchabstand) weniger als 100 µm beträgt.

5. Kontakt nach einem der Ansprüche 1 bis 4,
**dadurch gekennzeichnet, daß** das Bondelement aus Gold besteht.

6. Verfahren zum elektrischen und mechanischen Verbinden einer flächigen, dünnen Bondstruktur (1) mit einem festen Untergrund (4) mit Hilfe eines Bondkopfes (8) nach Anspruch 1,
**dadurch gekennzeichnet, daß** das Verfahren mittels eines Ultraschallschweißgerätes durchgeführt wird, wobei der Bondkopf durch ein Loch (2) in der Bondstruktur hindurch größtenteils direkt auf den Untergrund gebondet wird und die Bondstruktur dabei von dem Bondkopf gegen den Untergrund gepreßt wird.

7. Verfahren nach Anspruch 6,
**dadurch gekennzeichnet, daß** die Bondstruktur mit Hilfe des Lochs relativ zum Untergrund justiert wird.

8. Verfahren nach Anspruch 6 oder 7,
**dadurch gekennzeichnet, daß** der Bondkopf durch Anschmelzen eines Bonddrahtes zu einer Bondkugel gebildet wird.

9. Verfahren nach einem der Ansprüche 6 bis 8,
**dadurch gekennzeichnet, daß** der Bondkopf durch Umformen des Aluminiumdrahtes gebildet wird.

10. Verwendung des Verfahrens nach einem der Ansprüche 6 bis 9 zum elektrischen und mechanischen Verbinden von flexiblen, schmalen und/oder ultradünnen Leiterbahnen mit festen Substraten.

11. Verwendung nach Anspruch 10,
**dadurch gekennzeichnet, daß** die Breite der Leiterbahnen < 100 µm beträgt.

## Claims

1. Contact for extremely small bonding contacts, which connects mechanically and electrically a first part formed by a solid base (4) with a second part formed by a plane thin strip conductor (bond structure (1)) by means of a bond joint at a possible pitch distance between adjacent strip conductors of less than 100 µm,
**characterised in that** said second part has a hole (2), that said bond joint is substantially a bonding element (9) or a bond head, which extends from said base through said hole in said strip conductor up to a zone (5) located above said strip conductor, and that said bond element extends laterally, at least partly, beyond the hole in said strip conductor in the zone above said strip conductor, thus ensuring the contact of said first part with the underside of said strip conductor.

2. Contact according to Claim 1,
**characterised in that** said second part on its upper side is conductive in the vicinity of said hole and is electrically connected through said bond element to said first part.

3. Contact according to Claim 1,
**characterised in that** said second part is conductive on its underside in the vicinity of the hole, contacts the first part there and is electrically connected to said first part substantially by this provision.

4. Contact according to any of the Claims 1 to 3,
**characterised in that** several individual contacts are provided whose spacing (pitch distance) corresponds to less than 100 µm.

5. Contact according to any of the Claims 1 to 4,
**characterised in that** said bond element consists of gold.

6. Method of electrically and mechanically connecting a plane thin bond structure (1 ) to a solid base (4) by means of a bond head (8) according to Claim 1,
**characterised in that** the method is carried out by means of an ultrasonic welding device, with said bond head being bonded through a hole (2) in said bond structure, by the major part directly onto the base, while said bond structure is pressed by said bond head against said base.

7. Method according to Claim 6,
**characterised in that** said bond structure is adjusted by means of said hole relative to said base.

8. Method according to Claim 6 or 7,
**characterised in that** said bond head is formed by fusing a bonding wire so as to form a bonding ball.

9. Method according to any of the Claims 6 to 8,
**characterised in that** said bond head is formed by shaping said aluminium wire.

10. Application of the method according to any of the Claims 6 to 9 for electrically and mechanically connecting flexible narrow and/or ultra-thin strip conductors with solid substrates.

11. Application according to Claim 10,
**characterised in that** the width of said strip conductors is less than 100 µm.

## Revendications

1. Contact pour des contacts à bonding extrêmement petits, qui relie, de façon mécanique et électrique, un premier élément constitué par une base solide (4), à un deuxième élément, qui est constitué par une piste conductible plane mince (structure de bonding (1)) moyennant une jonction de bonding à une distance de pas possible entre des pistes conductibles voisines de moins de 100 µm,
**caractérisé en ce que** ledit deuxième élément a un trou (2), que ladite jonction de bonding est essentiellement un élément de bonding (9) ou une tête de bonding, qui s'étend à partir de ladite base à travers ledit trou dans ladite piste conductible jusqu'à une zone (5), qui se trouve au-dessus de ladite piste conductible, et **en ce que** ledit élément de bonding s'étend latéralement, au moins en partie, au-delà du trou dans ladite piste conductible dans la zone au-dessus de ladite piste conductible, en assurant ainsi le contact dudit premier élément avec la face inférieure de ladite piste conductible.

2. Contact selon la revendication 1,
**caractérisé en ce que** ledit deuxième élément a une face supérieure conductible au voisinage dudit trou, en étant raccordé, de façon électrique, à travers ledit élément de bonding audit premier élément.

3. Contact selon la revendication 1,
**caractérisé en ce que** ledit deuxième élément a une face inférieure conductible au voisinage dudit trou, s'y trouve en contact avec ledit premier élément et est raccordé, de façon électrique, audit premier élément essentiellement par cette mesure.

4. Contact selon une quelconque des revendications 1 à 3,
**caractérisé en ce que** plusieurs contacts individuels sont formés, dont l'écartement (distance de pas) l'un de l'autre correspond à moins de 100 µm.

5. Contact selon une quelconque des revendications 1 à 4,
**caractérisé en ce que** ledit élément de bonding consiste en or.

6. Procédé de raccorder, de façon électrique et mécanique, une structure de bonding (1) plane et mince à une base solide (4) moyennant une tête de bonding (8) selon la revendication 1,
**caractérisé en ce que** le procédé est réalisé au moyen d'un dispositif de soudage par les ultrasons, à adite tête de bonding étant jointe par bonding à travers un trou (2) dans ladite structure de bonding, par la plupart directement sur la base, pendant que ladite structure de bonding est pressée par ladite tête de bonding contre ladite base.

7. Procédé selon la revendication 6,
**caractérisé en ce que** ladite structure de bonding est ajustée moyennant ledit trou relativement à ladite base.

8. Procédé selon la revendication 6 ou 7,
**caractérisé en ce que** ladite tête de bonding est façonnée en mettant un fil de bonding en fusion afin de former une boule de bonding.

9. Procédé selon une quelconque des revendications 6 à 8,
**caractérisé en ce que** ladite tête de bonding est façonnée par façonnage dudit fil en aluminium.

10. Application du procédé selon une quelconque des revendications 6 à 9 pour le raccord électrique et mécanique afin de connecter des pistes conductibles flexibles étroites et/ou ultra-minces aux substrats solides.

11. Application selon la revendication 10,
**caractérisé en ce que** la largeur desdites pistes conductibles est moins de 100 µm,
